# EUROPÄISCHE PATENTSCHRIFT

(11) **EP 0 926 348 B1**
(45) Veröffentlichungstag und Bekanntmachung des Hinweises auf die Patenterteilung: **21.04.2004**
(21) Anmeldenummer: 98123877.7
(22) Anmeldetag: 16.12.1998
(51) Int. Cl.: F04D 29/70, F04D 29/62, F04D 29/64, F04D 29/60, H01L 23/467, H05K 7/20, G06F 1/20

(54) **Abdeckung für einen Lüfter**
Fan cover
Capot de ventilateur

(30) Priorität: 24.12.1997 DE 29722850 U
(43) Veröffentlichungstag der Anmeldung: 30.06.1999
(73) Patentinhaber: Papst-Motoren GmbH & Co. KG, 78112 St. Georgen (DE)
(72) Erfinder: Winkler, Wolfgang Arno, 78112 St. Georgen (DE)

(56) Entgegenhaltungen:
- US-A- 2 987 242
- US-A- 5 335 722
- US-A- 5 466 120
- US-A- 5 519 574

## Beschreibung

Die vorliegende Erfindung betrifft eine Abdeckung für einen Lüfter, der auf ein Basisteil montierbar und insbesondere zur Kühlung von auf dem Basisteil befindlichen elektronischen Baugruppen oder -elementen bestimmt ist, mit einer mit Luftdurchtrittsöffnungen versehenen Deckplatte sowie mit einerseits mit der Deckplatte verbundenen ersten Befestigungselementen und mit andererseits mit der Deckplatte verbundenen zweiten Befestigungselementen für das Basisteil, wobei die ersten Befestigungsetemente derart ausgebildet sind, dass die Deckplatte in einer zum Basisteil beabstandeten Lage (Abstand A) bei Zwischenanordnung des an der Deckplatte befestigbaren Lüfters am Basisteil lösbar befestigbar ist.

Bei dem Lüfter kann es sich beispielsweise um einen Axial- oder Radiallüfter handeln, wobei das Basisteil beispielsweise eine mit den elektronischen Bausteinen bestückte Leiterplatte, die CPU oder das Motherboard eines Computers bzw. auch ein vorzugsweise profilierter seinerseits zur Wärmeableitung von den elektronischen Bausteinen dienender Kühlkörper sein kann. Üblicherweise wird ein solcher Lüfter in montagetechnisch einfacher Weise mittels Befestigungselenienten direkt auf dem Basisteil befestigt, z.B. aufgesteckt, und ist dadurch leicht zugänglich. Für den elektrischen Anschluß weist der Lüfter Anschlußlitzen auf, deren Enden mit Steckem versehen sein können. Für den Transport werden diese Anschlußlitzen um den Lüfter gewickelt und mit einem Klebeband befestigt. Beim Betrieb muß einerseits zur Gewährleistung eines ungehinderten Luftzütritts und hoher Funktionssicherheit der Lüfter, insbesondere in seinem Luft-Ansaugbereich, vor der Anlage derartiger Litzen, Kabel, Stegleitungen usw., die auch von und zu anderen Baugruppen oder -elementen geführt sein können, geschützt werden. Andererseits muß der Kontakt elektrischer Verbindungsleitungen mit dem Lüfter, insbesondere mit dessen rotierenden Teilen, verhindert werden, um einer Zerstörung der elektrischen Verbindungsleitungen, dem Lösen von Steckverbindungen und - damit verbunden - der Gefahr einer Unterbrechung des Stromflusses oder des Auftretens von Kurzschlußströmen vorzubeugen.

Aus der US-A 5 355 722 ist eine Abdeckung der eingangs genannten Art bekannt, bei der erste und zweite Befestigungselemente vorhanden sind. Die zweiten Befestigungselemente sind für das Basisteil, einen Kühlkörper, vorgesehen. Die ersten Befestigungselemente sind für einen Chip, eine CPU, ausgebildet - und zwar derart, dass die Abdeckung an dem Chip verrastbar ist. An der dem Lüfter zugewandten Oberseite der Abdeckung sind zum Lüfter weisende federnde Zungen herausgeformt, die den Lüfter an seiner Oberseite berühren, diesen aber nicht befestigen. Die Zungen erlauben eine Verwendung von unterschiedlich dicken Chips. Weil an der bekannten Abdeckung Rastnasen vorgesehen sind, die so voneinander beabstandet sind, dass der Lüfter bei fehlendem Basisteil bzw. CPU leicht aus der Abdeckung (10) herausfallen würde ist eine Vormontage des Lüfters an der Abdeckung nicht möglich.

Der vorliegenden Erfindung liegt die Aufgabe zugrunde, eine in wenig aufwendiger Weise herstellbare Abdeckung der eingangs beschriebenen Art zu schaffen, die bei leichter Zugänglichkeit des Lüfters eine einfache, schnelle und sichere Montage gestattet und einen Kontakt des Lüfters, insbesondere in dessen Luft-Ansaugbereich mit in Lüftemähe geführten Litzen, Käbeln, Stegleitungen usw. wirksam verhindert, wobei auch eine einfache Handhabung bei einem Transport bzw. beim Versand gegeben sein soll.

Erfindungsgemäß wird dies durch eine Abdeckung der eingangs beschriebenen Art erreicht, bei der die ersten Befestigungselemente derart für den Lüfter ausgebildet sind, dass der Lüfter lösbar an der Abdeckung vormontierbar ist.

Eine solche Abdeckung kann bei hoher Funktionserfüllung, d.h. wirksamem Berührungsschutz des Lüfters, vorteilhafterweise ohne Werkzeuge oder Hilfseinrichtungen montiert werden. Die Montage erfolgt dabei erfindungsgemäß so, daß der Lüfter indirekt am Basisteil, d.h. zunächst der Lüfter an der Abdeckung, und dann die Abdeckung mit dem daran befindlichen Lüfter auf dem Basisteil, befestigt wird. Der erste Montageschritt kann dabei bereits beim Hersteller des Lüfters im Rahmen einer Vormontage vorgenommen werden, wodurch eine Lüfterbaugruppe mit der am Lüfter befestigten erfindungsgemäßen Abdeckung entsteht. Eine solche Baugruppe gestattet ein einfaches Handling und einen problemfreien Transport und kann so vorteilhafterweise als Ganzes zum Versand gebracht werden.

In einer vorteilhaften Weiterbildung kann die erfindungsgemäße Abdeckung mindestens zwei im wesentlichen im rechten Winkel zur Deckplatte stehende, einander gegenüberliegende Seitenwände aufweisen, die zur Erhöhung der Stabilität der Abdeckung dienen und eine Vielzahl mit weiteren Vorteilen verbundenen technischen Gestaltungsmöglichkeiten eröffnen können.

Die erfindungsgemäße Abdeckung erfüllt mit Vorteil eine Doppelfunktion für den Lüfter: Sie dient einerseits zu dessen Schutz und andererseits zur Halterung des Lüfters. Bevorzugt ist dabei auch eine Ausführung, bei der die Befestigungselemente für den Lüfter derart ausgebildet sind, daß der unterseitig an der Deckplatte befestigte, gegebenenfalls zwischen den Seitenwänden angeordnete, Lüfter eine zur Deckplatte beabstandete Lage einnimmt. Dadurch wird erstens günstigerweise der Sicherheitsabstand der rotierenden Lüfterteile zu über die Deckplatte geführten elektrischen Leitungen größer, zum zweiten steht über dem Lüfter ein freier Luftansaugraum mit größerem Volumen zur Verfügung.

Weitere vorteilhafte Ausgestaltungsmerkmale der Erfindung sind in den Unteransprüchen sowie der folgenden Beschreibung enthalten.

Anhand eines in der Zeichnung dargestellten, bevorzugten Ausführungsbeispiels soll im folgenden die Erfindung näher erläutert werden. Dabei zeigen:
- Fig. 1: teilweise aufgebrochen, eine Vorderansicht eines Lüfters mit einer erfindungsgemäßen Abdeckung im Montagezustand,
- Fig. 2: die Draufsicht auf eine erfindungsgemäßen Abdeckung für einen Lüfter,
- Fig. 3: die Vorderansicht der in Fig. 2 dargestellten erfindungsgemäßen Abdeckung,
- Fig. 4: einen Querschnitt durch die erfindungsgemäße Abdeckung entlang der Linie IV-IV in Fig. 3,
- Fig. 5: einen parallel zur Deckplatte entlang der Linie V-V in Fig. 3 verlaufenden Schnitt der erfindungsgemäßen Abdeckung.
- Fig. 6: eine gegenüber der Vorderansicht in Fig. 3 vergrößerte Einzelheit VI der erfindungsgemäßen Abdeckung.

In den verschiedenen Figuren der Zeichnung sind gleiche Teile mit denselben Bezugszeichen versehen, so daß sie in der Regel auch jeweils nur einmal beschrieben werden.

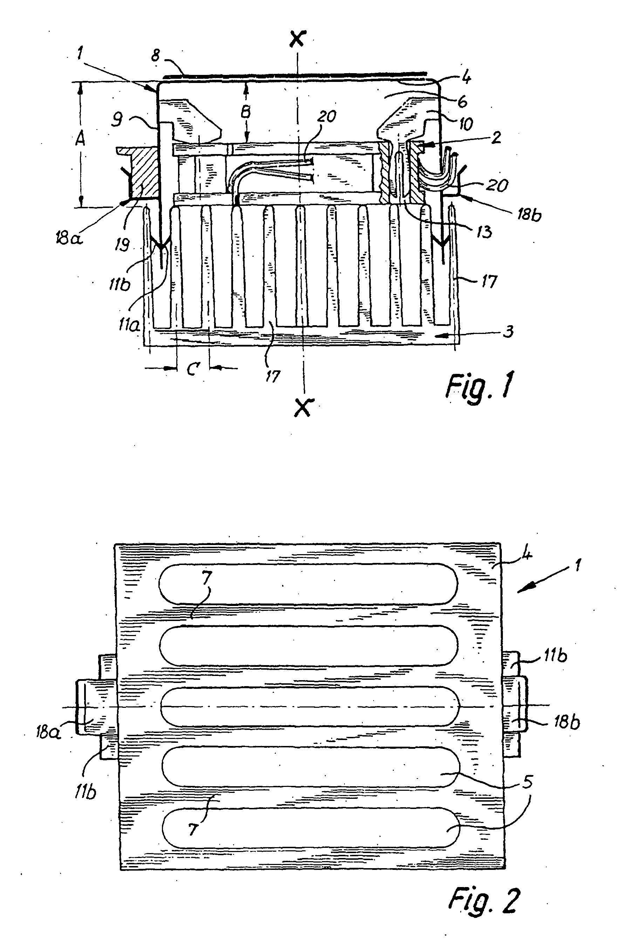

Wie sich aus Fig. 1 der Zeichnung ergibt, ist eine erfindungsgemäße Abdeckung 1 für einen Lüfter 2 bestimmt, der auf ein Basisteil 3 montierbar ist und insbesondere zur Kühlung von auf dem Basisteil 3 befindlichen elektronischen Baugruppen oder -elementen dient. Das Basisteil 3 ist in der dargestellten Ausführung ein zur Wärmeableitung von den elektronischen Bausteinen dienender Kühlkörper. Wie bereits erwähnt, kann es sich bei dem Basisteil 3 auch um eine bestückte Leiterplatte, eine CPU oder das Motherboard eines Computers handeln.

Der dargestellte Lüfter 2 ist ein Axiallüfter, der eine Längsachse X-X aufweist, in deren Richtung die Kühlluft in der Darstellung nach Fig. 1 von oben angesaugt und nach unten ausgeblasen wird. Die zu kühlenden elektronischen Baugruppen und -elemente selbst sind in der Zeichnung nicht dargestellt. Anstelle des Axiallüfters könnte auch ein Radiallüfter montiert sein, bei dem die Luftansaugung in gleicher Weise erfolgt, die Luft jedoch quer zur Längsachse X-X, d.h. in Fig. 1 seitlich ausgeblasen wird.

Wie Fig. 1 und insbesondere die in Fig. 2 dargestellte Draufsicht auf die erfindungsgemäße Abdeckung 1 veranschaulichen, weist die Abdeckung 1 eine Deckplatte 4 auf, die mit Luftdurchtrittsöffnungen 5 versehen ist. Die Luftdurchtrittsöffnungen 5 sind als sich nahezu über die gesamte Breite der Deckplatte 4 erstreckende Langlöcher ausgebildet, so daß die Deckplatte 4 eine rost- bzw. gitterartige Ausbildung besitzt. Die Luftdurchtrittsöffnungen 4 sichern den ungehinderten Luftzutritt in den Ansaugbereich 6 des Lüfters 2, während auf den zwischen den Luftdurchtrittsöffnungen 5 befindlichen Stegen 7 Litzen, Kabel, Stegleitungen oder andere elektrische Verbindungsleitungen, die in Fig. 1 mit dem Bezugszeichen 8 bezeichnet sind, geführt werden, können, ohne daß sie in Berührung mit dem Lüfter 2 kommen. Die Luftdurchtrittsöffnungen 4 können hinsichtlich ihrer Größe, Anordnung und Form in weitem Umfang beliebig gestaltet werden.

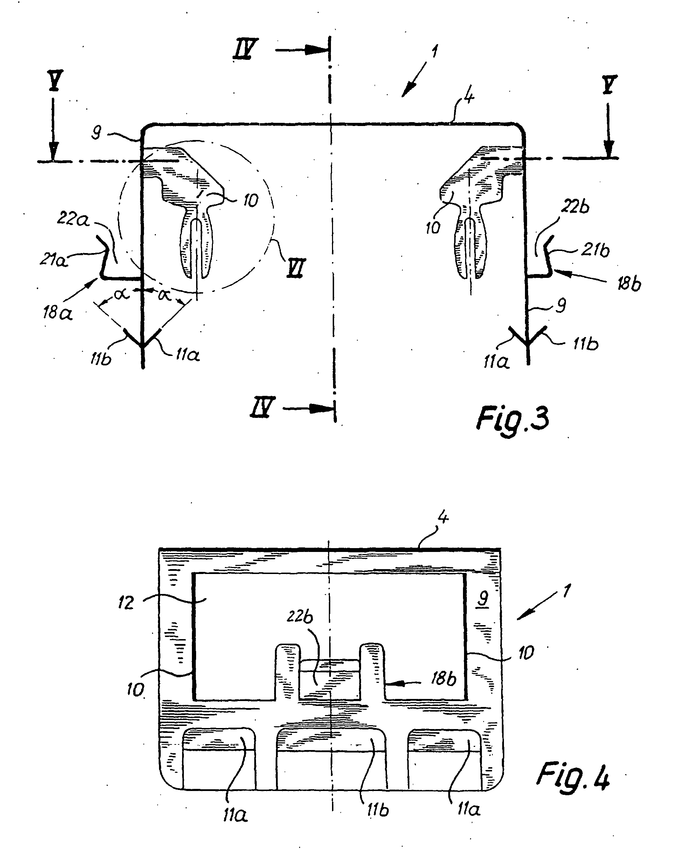

Fig. 3 bis 5 zeigen verschiedene weitere Ansichten der erfindungsgemäßen Abdeckung 1 in Einzeldarstellung - ohne Lüfter 2 und Basisteil 3. Wie daraus ersichtlich ist, besitzt die Abdeckung 1 vorzugsweise zwei im wesentlichen im rechten Winkel zur Deckplatte 4 stehende, einander gegenüberliegende Seitenwände 9. Die Abdeckung 1 weist so eine bügelförmige Grundgestalt auf, wobei der Quersteg (Deckplatte 4) des Bügels im Montagezustand den Lüfter 2 übergreift und die beiden freien Bügelenden (Seitenwände 9) mit dem Basisteil 3 lösbar verbunden werden können.

Die erfindungsgemäße Abdeckung 1 besitzt einerseits mit der Deckplatte 4 verbundene Befestigungselemente 10 für den Lüfter 2 und andererseits mit der Deckplatte 4 verbundene Befestigungselemente 11 für das Basisteil 3, wobei die Befestigungselemente 10, 11 derart ausgebildet sind, daß die Deckplatte 2 in einer zum Basisteil 3 beabstandeten Lage (Abstand A in Fig. 1) bei Zwischenanordnung des an der Deckplatte 4 befestigbaren Lüfters 2 am Basisteil 3 befestigbar ist. In der dargestellten Ausführung befinden sich die Befestigungslemente 10, 11 an den Seitenwänden 9, bzw. werden aus Teilen der Seitenwände 9 gebildet, wobei an jeder Seitenwand 9 zwei Befestigungselemente 10 für den Lüfter 2 angeordnet sind.

Die Befestigungselemente 10 für den Lüfter 2 sind des weiteren vorzugsweise derart ausgebildet, daß der unterseitig an der Deckplatte 4 befestigte, zwischen den Seitenwänden 9 angeordnete Lüfter 2 eine zur Deckplatte beabstandete Lage (Abstand B in Fig. 1) einnimmt. Der Abstand zwischen Lüfter 2 und Deckplatte 4 stellt einen Sicherheitsabstand dar, der gewährleistet, daß die rotierenden Teile des Lüfters 2 nicht mit den über die Deckplatte 4 geführten elektrischen Leitungen 8 in Kontakt kommen. Außerdem sichert der Abstand B ein ausreichendes freies Volumen des Ansaugraumes 6 über dem Lüfter 2, so daß jederzeit eine genügende Kühlluftmenge bereitgestellt werden kann.

Erfindungsgemäß dient die Abdeckung 1 auch zur Befestigung des Lüfters 2 am Basisteil 3. Dabei ist es von Vorteil, wenn die Befestigungselemente 10 für den Lüfter 2 federelastisch sind. Dadurch kann auf einfache Weise ein Lageausgleich des Lüfters 2 vorgenommen werden. Die Federelastizität der Befestigungselemente 10 für den Lüfter 2 kann beispielsweise dadurch erreicht werden, daß die Abdeckung 1 als Formteil aus Federblech oder auch als Spritzgußteil aus einem Kunststoff mit entsprechender Werkstoffcharakteristik ausgebildet ist.

Die Befestigungselemente 10 für den Lüfter 2 sind - wie dargestellt - als nach innen, d.h. unter die Deckplatte 4 in den Ansaugraum 6, gerichtete Ausklinkungen der Seitenwände 9 ausgebildet. Eine solche Ausbildung kann beispielsweise bei einem Blechformteil in fertigungstechnisch günstiger Weise durch ein Herausbiegen der Befestigungselemente 10 aus den Seitenwänden 9 erreicht werden, wodurch die Seitenwände 9 - wie für die Deckplatte 4 gezeigt - durch die dabei entstehenden Durchbrechungen 12 einen großen freien Querschnitt aufweisen, durch den Luft angesaugt werden kann.

Vorteilhafterweise sind die Befestigungselemente 10 für den Lüfter 2 als Rastelemente ausgebildet. Wie insbesondere die Darstellung als Einzelheit in Fig. 6 und der in Fig. 1 ausgebrochen dargestellte Bereich zeigen, umfassen die Befestigungselemente 10 für den Lüfter 2 zum rastenden Eingriff in im Lüfter 2 befindliche korrespondierende Öffnungen 13 einen Rastabschnitt 14, der als ein mit einem Schlitz 15 versehener federelastischer flacher Steg 16 mit konvexer Querschnittskontur ausgebildet ist. Bei einem Kunststoff-Spritzgußteil könnte anstelle des Steges 16 auch ein entsprechender geschlitzter Zapfen vorgesehen sein. Durch diese Ausbildung der Befestigungselemente 10 können die Teile des Steges 16 beim Einführen in die Öffnungen 13 des Lüfters 2 in Richtung auf den Schlitz 15 hin zusammengedrückt werden und halten beim anschließenden Auseinanderfedern in den Öffnungen 13 Lüfter 2 und Abdeckung 1 zusammen. Eine solche Verbindung kann leicht hergestellt und auch wieder gelöst werden. Hierbei ist zudem vorteilhaft, wenn jedes Befestigungselement 10 seitlich neben dem Steg 16 konvex gekrümmte Anlagebereiche 10a mit relativ großem Krümmungsradius derart aufweist, daß diese Anlagebereiche 10a - siehe Fig. 1 - zur Anlage am Öffnungsrand der jeweiligen Öffnung 13 gelangen und so für eine besonders gute Auflage sowie vorteilhafterweise auch für einen axialen Toleranz- bzw. Spielausgleich sorgen.

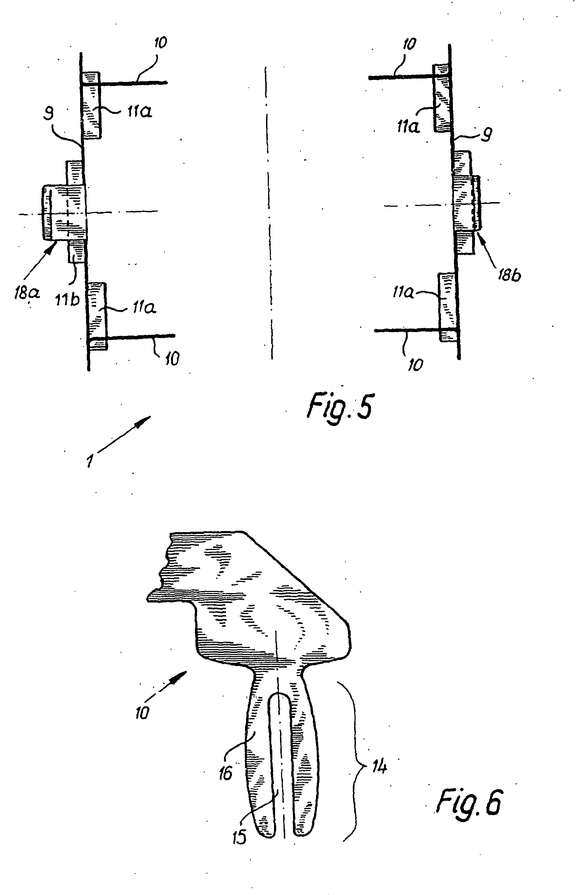

Im Gegensatz zum dargestellten Ausführungsbeispiel liegt es auch im Rahmen der Erfindung, wenn die Befestigungselemente 10 für den Lüfter 2 nicht von oben, sondern seitlich - oder auch an anderer Stelle als gezeigt - in den Lüfter 2 eingreifen, jedoch ist die dargestellte Ausführung insofern vorteilhaft, als dabei die vier bei handelsüblichen Lüftern vorhandenen Befestigungslöcher (Öffnungen 13) zur Halterung des Lüfters 2 genutzt werden können. Die symmetrische Anordnung der Befestigungselemente 10, die insbesondere aus Fig. 5 deutlich wird, sichert dabei insbesondere auch eine schwingungsarme und besonders stabile Befestigung des Lüfters 2.

Vorteilhafterweise können zur Herstellung einer leicht lösbaren Verbindung bei der erfindungsgemäßen Abdeckung 1 nicht nur die Befestigungslemente 10 für den Lüfter 2, sondern auch die Befestigungselemente 11a, 11b für das Basisteil 3 als Rastelemente ausgebildet sein.

Im vorliegenden Fall sind diese Befestigungselemente 11a, 11b für das Basisteil 3 als nach beiden Seiten der Seitenwände 9 gerichtete Ausklinkungen der Seitenwände 9 ausgebildet. Dies ist vornehmlich bei dem hier dargestellten Basisteil 3 von Vorteil, bei dem es sich um einen Profilkühlkörper handelt, der, wie Fig. 1 zeigt, regelmäßig beabstandete (Abstand C in Fig. 1) Kühlrippen 17 aufweist, zwischen die die Befestigungselemente 11a, 11b eingeführt werden können.

Die Befestigungselemente 11a, 11b für das Basisteil 3 sind dabei insbesondere als nach oben, d.h. in Richtung auf die Deckplatte 4 hin, gerichtete federelastische Ausklinkungen der Seitenwände 9 ausgebildet, die in spitzem Winkel α (hier 45°) zum übrigen Teil der Seitenwände 9 stehen. Dadurch bilden die Befestigungselemente 11a, 11b der Montagerichtung der Abdeckung 1 entgegengerichtete Widerhaken, die sich im Basisteil 3 verkrallen können. In der dargestellten Ausführung (vgl. insbesondere Fig. 5) sind am unteren, d.h. von der Deckplatte 4 wegweisenden, Ende jeder Seitenwand 9 randseitig jeweils zwei, nach einer Seite der Wand 9, z.B. unter die Deckplatte 4, weisende Ausklinkungen 11a und mittig jeweils eine, nach der anderen Seite der Wand 9 weisende Ausklinkung 11b angeordnet. Alternativ können auch, z.B. tannenbaumförmige, Mehrfach-Ausklinkungen der Seitenwände 9 vorgesehen sein. Die derartig als Verkrallungselemente ausgebildeten Befestigungselemente 11a, 11b können, da sie nach dem Einführen zwischen die Rippen 17 des Kühlkörpers unter einer mechanischen Spannung stehen, auch zur Kompensation des sich unter dem Einfluß Wärmeausdehnung ändernden Abstands C zwischen den Kühlrippen 17 dienen. Durch eine solche oder ähnliche kraft- und/oder formschlüssige Verbindung zwischen der mit dem Lüfter 2 verbundenen Abdeckung 1 und dem Basisteil 3 kann der Lüfter 2 auf dem Basisteil 3 immer fest aufliegen, was vorteilhafterweise im Betriebszustand auch eine Geräuschminderung bewirkt.

Wie aus den Zeichnungsfiguren ersichtlich ist, weist die erfindungsgemäße Abdeckung 1 noch eine andere insbesondere im Hinblick auf Transport und Handling vorteilhafte Weiterbildung auf: An den beiden Seitenwänden 9 ist jeweils ein Aufnahmeteil 18a, 18b für gegebenenfalls mit Steckern 19 versehene Anschlußlitzen 20 (Fig. 1) des Lüfters 2 angeordnet. Zur kraftschlüssigen Halterung der Anschlußlitzen 20 bzw. der Stecker 19 sind die Aufnahmeteile 18a, 18b als federelastische Klammern ausgebildet. Die Aufnahmeteile 18a, 18b sind nach außen, d.h. vom Ansaugraum 6 unter der Deckplatte 4 weggerichtete Ausklinkungen der Seitenwände 9. Sie weisen jeweils einen nach oben, d.h. in Richtung der Deckplatte 4, gerichteten Stegabschnitt 21a, 21b derart auf, daß entlang der Seitenwände 9 Taschenabschnitte 22a, 22b ausgebildet sind, die geeignet sind, die Stecker 19 bzw. Anschlußlitzen 20 aufzunehmen und kraftschlüssig zu arretieren. Die an den beiden gegenüberliegenden Seitenwänden 9 befindlichen Aufnahmeteile 18a, 18b können sich dabei zur Halterung unterschiedlich großer Stecker 19 (z.B. Berg-Stecker, Molex-Stecker) in ihrer Größe unterscheiden, wodurch sie für den elektrischen Anschluß des Lüfters 2 bei der Montage gleichzeitig eine Markierungsfunktion erfüllen.

Für ein störungsfreies Handling und einen bequemen Transport ohne notwendige vorhergehende Verpackungsvorgänge, aber auch im Montagezustand, können die Stecker 19 bzw. Anschlußlitzen 20 in den Aufnahmeteilen 18a, 18b gehalten sein, insbesondere nachdem der Lüfter 2 an der Abdeckung 1 im Rahmen einer z.B. herstellerseitig erfolgten Vormontage befestigt und dadurch eine versand- und endmontagefertige Lüfterbaugruppe hergestellt wurde.

Die Erfindung ist nicht auf die beschriebenen Ausführungsbeispiele beschränkt, sondern umfaßt auch alle im Sinne der Erfindung gleichwirkenden Ausführungen. Insbesondere können z.B. die Befestigungselemente für das Basisteil 3 bedarfsweise, insbesondere wenn es sich nicht um einen Kühlkörper handelt, als Rastelemente mit Rastnasen ausgebildet sein, die z.B. in komplementäre Rastöffnungen in einer Platine eingreifen können. Ebenso liegt es im Rahmen der Erfindung, wenn im Sinne einer höheren Stabilität die Abdeckung 1 vier Seitenwände 9 aufweist oder wenn sie in Anpassung an die Form des Lüfters 2 - im Gegensatz zur Darstellung in Fig. 2 - eine in der Draufsicht runde Form mit nur einer umlaufenden Seitenwand 9 aufweist.

Neben den beiden genannten Funktionen kann die erfindungsgemäße Abdeckung 1 des weiteren auch die Funktion eines wärmeableitenden Teils erfüllen und zur Vergrößerung der Wärmeaustauschfläche zu diesem Zweck einen Überzug aus Strukturlack aufweisen.

Des weiteren kann die erfindungsgemäße Abdeckung 1 mit Vorteil vornehmlich einstückig ausgebildet sein.

## Patentansprüche

1. Abdeckung für einen Lüfter (2), der auf ein Basisteil (3) montierbar und insbesondere zur Kühlung von auf dem Basisteil (3) befindlichen elektronischen Baugruppen oder -elementen bestimmt ist, mit einer mit Luftdurchtrittsöffnungen (5) versehenen Deckplatte (4) sowie mit einerseits mit der Deckplatte (4) verbundenen ersten Befestigungselementen (10) und mit andererseits mit der Deckplatte (4) verbundenen zweiten Befestigungselementen (11a, 11b) für das Basisteil (3), wobei die ersten Befestigungselemente (10) derart ausgebildet sind, dass die Deckplatte (4) in einer zum Basisteil (3) beabstandeten Lage (Abstand A) bei Zwischenanordnung des an der Deckplatte (4) befestigbaren Lüfters (2) am Basisteil (3) lösbar befestigbar ist,
**dadurch gekennzeichnet, dass** die ersten Befestigungselemente (10) derart für den Lüfter (2) ausgebildet sind, dass der Lüfter (2) lösbar an der Abdeckung vormontierbar ist.

2. Abdeckung nach Anspruch 1,
**gekennzeichnet durch** mindestens zwei im wesentlichen im rechten Winkel zur Deckplatte (4) stehende, einander gegenüberliegende Seitenwände (9).

3. Abdeckung nach Anspruch 1 oder 2,
**dadurch gekennzeichnet, daß** die Befestigungselemente (10) für den Lüfter (2) ausgebildet sind, daß der unterseitig an der Deckplatte (4) lösbar befestigte, gegebenenfalls zwischen den Seitenwänden (9) angeordnete, Lüfter (2) eine zur Deckplatte (4) beabstandete Lage (Abstand B) einnimmt.

4. Abdeckung nach einem der Ansprüche 1 bis 3,
**dadurch gekennzeichnet, daß** die Befestigungselemente (10) für den Lüfter (2) federelastisch sind.

5. Abdeckung nach einem der Ansprüche 2 bis 4,
**dadurch gekennzeichnet, daß** die Befestigungselemente (10) für den Lüfter (2) an den einander gegenüberliegenden Seitenwänden (9) angeordnet sind.

6. Abdeckung nach einem der Ansprüche 2 bis 5,
**dadurch gekennzeichnet, daß** die Befestigungselemente (10) für den Lüfter (2) als nach innen, d.h. unter die Deckplatte (4), gerichtete Ausklinkungen der Seitenwände (9) ausgebildet sind.

7. Abdeckung nach einem der Ansprüche 1 bis 6,
**dadurch gekennzeichnet, daß** die Befestigungselemente (10) für den Lüfter (2) als Rastelemente ausgebildet sind.

8. Abdeckung nach Anspruch 7,
**dadurch gekennzeichnet, daß** die Befestigungselemente für den Lüfter (2) zum rastenden Eingriff in im Lüfter (2) befindliche Öffnungen (13) einen Rastabschnitt (14) umfassen, der als ein mit einem Schlitz (15) versehener federelastischer Steg (16) oder Zapfen mit konvexer Querschnittskontur ausgebildet ist.

9. Abdeckung nach einem der Ansprüche 2 bis 8,
**dadurch gekennzeichnet , daß** an jeder Seitenwand (9) zwei Befestigungselemente (10) für den Lüfter (2) angeordnet sind.

10. Abdeckung nach einem der Ansprüche 1 bis 9,
**dadurch gekennzeichnet, daß** die Befestigungselemente (11a, 11b) für das Basisteil (3) als Rastelemente ausgebildet sind.

11. Abdeckung nach einem der Ansprüche 2 bis 10,
**dadurch gekennzeichnet, daß** die Befestigungselemente (11a, 11b) für das Basisteil (3) als nach beiden Seiten der Seitenwände (9) gerichtete Ausklinkungen der Seitenwände (9) ausgebildet sind.

12. Abdeckung nach einem der Ansprüche 2 bis 11,
**dadurch gekennzeichnet, daß** die Befestigungselemente für das Basisteil (3) als nach oben, d.h. in Richtung auf die Deckplatte (4) hin, gerichtete Ausklinkungen der Seitenwände (9) ausgebildet sind, wobei die Ausklinkungen in spitzem Winkel (α) zum übrigen Teil der Seitenwände (9) stehen.

13. Abdeckung nach einem der Ansprüche 2 bis 12,
**dadurch gekennzeichnet, daß** die Befestigungselemente (11a, 11b) für das Basisteil (3) als, z.B. tannenbaumförmige, Mehrfach-Ausklinkungen der Seitenwände (9) ausgebildet sind.

14. Abdeckung nach einem der Ansprüche 11 bis 13,
**dadurch gekennzeichnet, daß** am unteren, d.h. von der Deckplatte (4) wegweisenden, Ende jeder Seitenwand (9) randseitig mindestens jeweils zwei, nach einer Seite der Seitenwand (9), z.B. unter die Deckplatte (4), weisende Ausklinkungen (11a) und mittig mindestens jeweils eine nach der anderen Seite der Seitenwand (9) weisende Ausklinkung (11b) angeordnet sind.

15. Abdeckung nach einem der Ansprüche 2 bis 14,
**dadurch gekennzeichnet, daß** an mindestens einer Seitenwand (9) ein Aufnahmeteil (18a oder 18b) für, gegebenenfalls mit Steckern (19) versehene, Anschlußlitzen (20) des Lüfters (2) angeordnet ist.

16. Abdeckung nach Anspruch 15,
**dadurch gekennzeichnet, daß** das Aufnahmeteil (18a, 18b) zur kraftschlüssigen Halterung der Anschlußlitzen (20) und gegebenenfalls der Stecker (19) federelastisch ist.

17. Abdeckung nach Anspruch 15 oder 16,
**dadurch gekennzeichnet, daß** das Aufnahmeteil (18a, 18b) als nach außen, d.h. vom Ansaugbereich (6) unter der Deckplatte (4) weg, gerichtete Ausklinkung der Seitenwand (9) ausgebildet ist.

18. Abdeckung nach einem der Ansprüche 15 bis 17,
**dadurch gekennzeichnet, daß** das Aufnahmeteil (18a, 18b) einen nach oben, d.h. in Richtung der Deckplatte (4), gerichteten Stegabschnitt (21a, 21b) derart aufweist, daß an der Seitenwand (9) ein Taschenabschnitt (22a, 22b) ausgebildet ist.

19. Abdeckung nach einem der Ansprüche 15 bis 18,
**dadurch gekennzeichnet, daß** an beiden gegenüberliegenden Seitenwänden (9) jeweils ein Aufnahmeteil (18a, 18b) angeordnet ist, wobei sich die Aufnahmeteile (18a, 18b) zur Halterung unterschiedlich großer Stecker (19) in ihrer Größe unterscheiden.

20. Abdeckung nach einem der Ansprüche 1 bis 19,
**gekennzeichnet durch** eine einstückige Ausbildung, insbesondere als Blechform- oder Kunststoffspritzgußteil.

21. Abdeckung nach einem der Ansprüche 1 bis 20,
**gekennzeichnet durch** einen Überzug aus Strukturlack.

22. Lüfterbaugruppe mit einem Lüfter (2) , der insbesondere zur Kühlung von auf einem Basisteil (3) befindlichen elektronischen Baugruppen oder -elementen bestimmt ist,
**gekennzeichnet durch** eine am Lüfter (2) befestigte Abdeckung (1) nach einem der Ansprüche 1 bis 21.

## Claims

1. Cover for a fan (2) which can be mounted on a base part (3) and is intended in particular for cooling of electronic assemblies or elements located on the base part (3), having a cover plate (4) provided with openings (5) for passage of air, and firstly first fastening elements (10) connected to the cover plate (4) and secondly second fastening elements (11a, 11b) connected to the cover plate (4) for the base part (3), the first fastening elements (10) being embodied such that the cover plate (4) can be fastened detachably to the base part (3) in a position a distance from the base part (3) (distance A) with the fan (2) fastenable to the cover plate (4) arranged in between, **characterised in that** the first fastening elements (10) for the fan (2) are embodied such that the fan (2) can be preassembled detachably on the cover.

2. Cover according to claim 1, **characterised by** at least two facing side walls (9) standing essentially at right angles to the cover plate (4).

3. Cover according to claim 1 or 2, **characterised in that** the fastening elements (10) for the fan (2) are embodied such that the fan (2) fastened detachably to the underside of the cover plate (4) and possibly arranged between the side walls (9) adopts a position a distance from the cover plate (4) (distance B).

4. Cover according to one of claims 1 to 3, **characterised in that** the fastening elements (10) for the fan (2) are springily elastic.

5. Cover according to one of claims 2 to 4, **characterised in that** the fastening elements (10) for the fan (2) are arranged on the facing side walls (9).

6. Cover according to one of claims 2 to 5, **characterised in that** the fastening elements (10) for the fan (2) are embodied as notches which are directed inwards, i.e. under the cover plate (4), and formed on the side walls (9).

7. Cover according to one of claims 1 to 6, **characterised in that** the fastening elements (10) for the fan (2) are embodied as latching elements.

8. Cover according to claim 7, **characterised in that** for latching engagement in openings (13) located in the fan (2) the fastening elements for the fan (2) comprise a latching portion (14) which is embodied as a springily elastic strip (16) or peg provided with a slot (15) and having a convex cross-sectional contour.

9. Cover according to one of claims 2 to 8, **characterised in that** two fastening elements (10) for the fan (2) are arranged on each side wall (9).

10. Cover according to one of claims 1 to 9, **characterised in that** the fastening elements (11a, 11b) for the base part (3) are embodied as latching elements.

11. Cover according to one of claims 2 to 10, **characterised in that** the fastening elements (11a, 11b) for the base part (3) are embodied as notches which are directed to both sides of the side walls (9) and formed on the side walls (9).

12. Cover according to one of claims 2 to 11, **characterised in that** the fastening elements for the base part (3) are embodied as notches which are directed upwards, i.e. in the direction of the cover plate (4), and formed on the side walls (9), the notches standing at an acute angle (α) to the remaining part of the side walls (9).

13. Cover according to one of claims 2 to 12, **characterised in that** the fastening elements (11a, 11b) for the base part (3) are embodied as for example fir tree-shaped multiple notches which are formed on the side walls (9).

14. Cover according to one of claims 11 to 13, **characterised in that** at the lower end of each side wall (9), i.e. the end pointing away from the cover plate (4), there are in each case at least two notches (11a) pointing towards one side of the side wall (9), e.g. under the cover plate (4), at the edges, and at least one notch (11b) pointing towards the other side of the side wall (9) in the middle.

15. Cover according to one of claims 2 to 14, **characterised in that** a receiving part (18a or 18b) for stranded connecting leads (20) for the fan (2), possibly provided with connectors (19), is arranged on at least one side wall (9).

16. Cover according to claim 15, **characterised in that** the receiving part (18a, 18b) is springily elastic for force-locking retention of the stranded connecting leads (20) and possibly the connectors (19).

17. Cover according to claim 15 or 16, **characterised in that** the receiving part (18a, 18b) is embodied as a notch which is directed outwards, i.e. away from the intake area (6) under the cover plate (4), and formed on the side wall (9).

18. Cover according to one of claims 15 to 17, **characterised in that** the receiving part (18a, 18b) comprises a strip portion (21a, 21b) which is directed upwards, i.e. in the direction of the cover plate (4), such that a pocket portion (22a, 22b) is formed on the side wall (9).

19. Cover according to one of claims 15 to 18, **characterised in that** a receiving part (18a, 18b) is arranged on both facing side walls (9), the receiving parts (18a, 18b) being of different size for retention of different sizes of connector (19).

20. Cover according to one of claims 1 to 19, **characterised by** a one-piece design, in particular as a formed sheet-metal part or plastic injection moulding.

21. Cover according to one of claims 1 to 20, **characterised by** a coating of texture paint.

22. Fan assembly with a fan (2) which is designed in particular for cooling of electronic assemblies or elements located on a base part (3), **characterised by** a cover (1) according to one of claims 1 to 21 fastened to the fan (2).

## Revendications

1. Capot pour un ventilateur (2), susceptible d'être monté sur une partie de base (3) et, en particulier, conçu pour le refroidissement de composants ou d'éléments électroniques, se trouvant sur la partie de base (3), avec une plaque de capot (4) munie d'ouvertures de passage d'air (5), ainsi qu'avec des premiers éléments de fixation (10), reliés, d'une part, à la plaque de capot (4), et avec des deuxièmes éléments de fixation (11a, 11b), reliés, d'autre part, à la plaque de capot (4), pour la partie de base (3), sachant que les premiers éléments de fixation (10) sont conformés de manière que la plaque de capot (4) puisse être fixée de façon désolidarisable en une position (espacement A) espacée de la partie de base (3), en cas d'agencement intermédiaire du ventilateur (3), susceptible d'être fixé sur la plaque de capot (4), sur la partie de base (3),
**caractérisé en ce que** les premiers éléments de fixation (10) sont réalisés pour le ventilateur (2), de manière que le ventilateur (2) puisse être prémonté de façon désolidarisable sur le capot.

2. Capot selon la revendication 1, **caractérisé par** au moins deux parois latérales (9) opposées l'une à l'autre, disposées sensiblement à angle droit par rapport à la plaque de capot (4).

3. Capot selon la revendication 1 ou 2, **caractérisé en ce que** les éléments de fixation (10) sont réalisés pour le ventilateur (2), **en ce que** le ventilateur (2), disposé le cas échéant entre les parois latérales (9), fixé de façon désolidarisable en face inférieure à la plaque de capot (4), prend une position (Espacement B) espacée de la plaque de capot (4).

4. Capot selon l'une des revendications 1 à 3, **caractérisé en ce que** les éléments de fixation (10) pour le ventilateur (2) sont dotés de l'élasticité d'un ressort.

5. Capot selon l'une des revendications 2 à 4, **caractérisé en ce que** les éléments de fixation (10) pour le ventilateur (2) sont disposés sur les parois latérales (9) opposées l'une à l'autre.

6. Capot selon l'une des revendications 2 à 5, **caractérisé en ce que** les éléments de fixation (10) pour le ventilateur (2) sont réalisés sous la forme d'excroissances des parois latérales (9), orientées vers l'intérieur, c'est-à-dire au-dessous de la plaque de capot (4).

7. Capot selon l'une des revendications 1 à 6, **caractérisé en ce que** les éléments de fixation (10) pour le ventilateur (2) sont réalisés sous la forme d'éléments d'encliquetage.

8. Capot selon la revendication 7, **caractérisé en ce que** les éléments de fixation pour le ventilateur (2) comprennent, pour assurer la mise en prise avec encliquetage dans des ouvertures (13) ménagées dans le ventilateur (2), un tronçon d'encliquetage (14) qui est réalisé sous forme d'une nervure (16), ayant l'élasticité d'un ressort, munie d'une fente (15), ou bien d'un téton à contour de section transversale convexe.

9. Capot selon l'une des revendications 2 à 8, **caractérisé en ce que** deux éléments de fixation (10) pour le ventilateur (2) sont disposés sur chaque paroi latérale (9).

10. Capot selon l'une des revendications 1 à 9, **caractérisé en ce que** les éléments de fixation (11a, 11b) pour la partie de base (3) sont réalisés sous la forme d'éléments d'encliquetage.

11. Capot selon l'une des revendications 2 à 10, **caractérisé en ce que** les éléments de fixation (11a, 11b) pour la partie de base (3) sont réalisés sous la forme d'excroissances des parois latérales (9), orientées vers les deux côtés des parois latérales (9).

12. Capot selon l'une des revendications 2 à 11, **caractérisé en ce que** les éléments de fixation pour la partie de base (3) sont réalisés sous la forme d'excroissances des parois latérales (9), orientées vers le haut, c'est-à-dire dans la direction de la plaque de capot (4), les excroissances étant placées sous un angle (α) aigu par rapport au reste des parois latérales (9).

13. Capot selon l'une des revendications 2 à 12, **caractérisé en ce que** les éléments de fixation (11a, 11b) pour la partie de base (3) sont réalisés sous la forme d'excroissances multiples, par exemple en forme de sapin, des parois latérales (9).

14. Capot selon l'une des revendications 11 à 13, **caractérisé en ce que**, à l'extrémité inférieure, c'est-à-dire s'écartant de la plaque de capot (4), de chaque paroi latérale (9) sont disposées, côté bordure, au moins chaque fois deux excroissances (11a), tournées vers un côté de la paroi latérale (9), par exemple au-dessous de la plaque de capot (4) et, centralement, est chaque fois disposée au moins une excroissance (11b), tournée vers l'autre côté de la paroi latérale (9).

15. Capot selon l'une des revendications 2 à 14, **caractérisé en ce qu'**une pièce de réception (18a ou 18b), pour des torons de raccordement (20), le cas échéant munis de connecteurs mâles (19), du ventilateur (2) est disposée sur au moins une paroi latérale (9).

16. Capot selon la revendication 15, **caractérisé en ce que** la pièce de réception (18a, 18b) présente l'élasticité d'un ressort pour assurer la fixation, par une liaison à interaction de force, des torons de raccordement (20) et, le cas échéant, des connecteurs mâles (19).

17. Capot selon la revendication 15 ou 16, **caractérisé en ce que** la pièce de réception (18a, 18b) est réalisée sous la forme d'excroissances de la paroi latérale (9), orientées vers l'extérieur, c'est-à-dire s'écartant de la zone d'aspiration (6), sous la plaque de capot (4).

18. Capot selon l'une des revendications 15 à 17, **caractérisé en ce que** la pièce de réception (18a, 18b) présente un tronçon de nervure (21a, 21b), tourné vers le haut, c'est-à-dire dans la direction de la plaque de capot (4), de manière qu'un tronçon de poche (22a, 22b) soit réalisé sur la paroi latérale (9).

19. Capot selon l'une des revendications 15 à 18, **caractérisé en ce que**, sur chacune des deux parois latérales (9) opposées, est disposée une pièce de réception (18a, 18b), les pièces de réception (18a, 18b) étant de taille différente, afin d'assurer la fixation de connecteurs males (19) de taille différente.

20. Capot selon l'une des revendications 1 à 19, **caractérisé par** une réalisation d'une seule pièce, en particulier sous forme de pièce formée en tôle ou de pièce moulée par injection en matière synthétique.

21. Capot selon l'une des revendications 1 à 20, **caractérisé par** un revêtement formé d'un vernis structuré.

22. Groupe de ventilateur muni d'un ventilateur (2), conçu en particulier pour le refroidissement de composants ou d'éléments électroniques se trouvant sur une partie de base (3), **caractérisé par** un capot (1), fixé sur le ventilateur (2), selon l'une des revendications 1 à 21.
